(19) **Europäisches Patentamt**

**European Patent Office**

**Office européen des brevets**

(11) **EP 1 066 680 B1**

(12) **EUROPEAN PATENT SPECIFICATION**

(45) Date of publication and mention
of the grant of the patent:
**11.06.2003 Bulletin 2003/24**

(51) Int Cl.7: **H03F 1/32**

(86) International application number:
**PCT/GB99/00695**

(21) Application number: **99907736.5**

(22) Date of filing: **08.03.1999**

(87) International publication number:
**WO 99/045638 (10.09.1999 Gazette 1999/36)**

(54) **PREDISTORTER**

VORVERZERRER

GENERATEUR DE PREDISTORSION

(84) Designated Contracting States:
**DE FI FR SE**

(30) Priority: **06.03.1998 GB 9804745**

(43) Date of publication of application:
**10.01.2001 Bulletin 2001/02**

(73) Proprietor: **Wireless Systems International
Limited
Bristol BS16 1EJ (GB)**

(72) Inventor: **KENNINGTON, Peter
Chepstow NP6 6PE (GB)**

(74) Representative: **Hogg, Jeffery Keith et al
Withers & Rogers,
Goldings House,
2 Hays Lane
London SE1 2HW (GB)**

(56) References cited:
**EP-A- 0 678 976      DE-A- 2 306 294
US-A- 3 732 502      US-A- 4 329 655
US-A- 5 164 678**

## Description

This invention relates to a circuit for deriving a third order signal from an input signal. In particular, the invention relates to a circuit for use in a polynomial predistorter.

In an ideal system, a linear amplifier provides uniform gain throughout its dynamic range in order that the output signal of the amplifier is a correct, amplified version of the input signal. In reality however all linear amplifiers exhibit non-ideal properties such as amplitude and phase distortion, which are undesirable and can seriously deteriorate the performance of a system. One effect of this non-linearity of the amplifier is the generation of output frequencies equal to the sums and differences of integer multiples of the input frequency components. This effect is known as intermodulation distortion (IMD) and is particularly undesirable in high-power radio frequency (RF) amplifiers designed for use in broadband systems. For example, a broadband amplifier used in the TDMA cellular system will generate various intermodulation products as a result of amplifying a multitude of TDMA channels occurring at fixed frequency intervals across a TDMA band, with coincident active frames.

A number of linearisation techniques have been developed to overcome the above distortion problems associated with a linear amplifier. A few of these techniques operate in real-time to account for time dependent changes in the non-linear characteristics of the amplifier. Such changes may result from, for example, temperature variations in the amplifier, aging of amplifier components, power supply fluctuations, or, most importantly, the input carriers. Of the broadband, RF-based linearisation techniques, the two most commonly used are feed forward linearisation and predistorter linearisation.

A feed forward linearisation mechanism relies on creating an error signal representative of the IMD products introduced by the linear amplifier, and feeding this signal forward to combine with the output spectrum of the amplifier, cancelling out the unwanted distortion. In order for the cancellation process to operate correctly, it is necessary for the mechanism to accurately adjust the amplitude and phase of the error signal prior to combining it with the output of the amplifier. This typically involves the use of additional amplifiers and lossy delay lines and couplers appearing in the output path from the main amplifier. These losses and the requirement for additional amplifiers, which are not adding to the output power of the system, result in a low-efficiency solution.

In general, predistortion linearisation mechanisms involve deliberate alteration of the relatively low level input signal to the amplifier in anticipation of the undesired distortion process occurring within the amplifier. Specifically, the mechanism predistorts the input signal in a inverse sense to the distortion produced by the amplifier such that in series the overall distortion is minimised. Accordingly, the transfer characteristic of the predistorter is approximated as closely as possible to the inverse or complementary function of the transfer characteristic of the amplifier. If the linear amplifier is compressive, i.e. the gain tails off at higher power levels, then the predistorter will compensate for this compression by correspondingly expanding the input signal.

Several approaches exist for predistorting the input signal, each differing in the way the predistorter approximates the inverse or complementary function. One approach approximates the inverse function with the exponential characteristics of a diode. One or more diodes may be used together with appropriate biasing to achieve a reduction of the distortion in the order of 10 dB. A second approach is to perform a piece-wise approximation of the inverse function using a series of linear gain, straight line elements interconnected end-to-end. A drawback with this approach is that the alignment and control of the line elements requires complex circuitry owing to the interconnection points having two degrees of freedom.

Polynomial predistortion is another approach to approximating the inverse function of the amplifier transfer characteristic. It is based on a polynomial expansion of the inverse function which may be expressed as follows:

$$y = a + bx + cx^2 + dx^3 + ex^4 + fx^5 + gx^6 + hx^7....$$

The term a is an offset which may be set to zero in a practical polynomial predistorter. The term bx represents the gain of the predistorter which is linear and merely contributes to the gain of the main amplifier. The terms containing even powers of x represent harmonic distortion components generated in the main amplifier which may be removed using frequency filtering, and therefore these terms may also be set to zero. The remaining terms containing odd powers of x represent in-band distortion caused by the main amplifier (in addition to harmonics which can be filtered as above). In fact, each of these odd-power terms may be considered to represent the equivalent order of intermodulation distortion generated in the main amplifier. A circuit implementing this approach is disclosed in DE-A-2 306 294.

According to a first aspect of the present invention there is provided a circuit for deriving a third order signal from an input signal, comprising input means for providing an input signal to the circuit along first, second and third paths, means for combining the input signal from the first and second paths to produce a second order signal on a squared signal path, means for low-pass filtering the second order signal to remove components at the frequency of the input signal and harmonics thereof, and means for combining the filtered second order signal from the squared signal path with the input signal from the third path to produce a third order signal.

A circuit in accordance with the first aspect of the present invention provides the advantage that the third order signal generation may take place using relatively low frequency technology to combine the second and first order signals. The generation of second and third order signals may also enable the generation of higher-order terms of distortion component such as fifth or seventh order.

Ideally, the input signal is a radio frequency (RF) signal which may contain a plurality of channels across a signal bandwidth.

In a first embodiment in accordance with the invention, the third order signal is provided as a third order distortion component at an output of the circuit.

In a second embodiment in accordance with the invention, the circuit further comprising means for providing the second order signal along a second squared path, and means for combining the second order signal from the second squared path with the third order signal to produce a fifth order signal.

In a third embodiment in accordance with the invention, the circuit is for deriving a fifth order signal from an input signal, whereby the input means provides the input signal along fourth and fifth paths, and further comprises means for combining the input signal from the fourth path with the third order signal to produce a fourth order signal, and means for combining the input signal from the fifth path with the fourth order signal to produce a fifth order signal.

A similar approach may be used in the generation of a seventh order distortion component at an output of the circuit.

The third order signal may contain input signal energy. Similarly, the fifth order signal may contain both input signal energy and third order signal energy.

In a preferred embodiment of the invention, the circuit further comprising means for injecting a direct current (DC) signal either directly into at least one of the signal paths and/or into at least one of the means for combining the signals. Depending on the injection position, the effect of the DC signal is to remove input signal energy from the third order signal, or to remove input signal energy and third order signal energy from the fifth order signal.

In the first embodiment, the DC signal is ideally injected into the squared path to add to the second order signal. The DC signal may also be injected in the first, second or third paths to achieve the same effect.

In the second embodiment, the DC signal is ideally injected into the second squared path to add to the second order signal.

The DC injection may be controlled (maintained) by an error correction or feedback loop. Suitably, the feedback loop is arranged so as to optimise removal of unwanted signal energies which occur in the third and fifth order signals.

Preferably, the feedback loop makes use of digital signal processing (DSP) techniques to reduce the effect of DC offsets produced by analogue components.

Preferably, the means for combining may be a mixer or a multiplier, and the means for providing a signal along more than one path may include at least one splitter for splitting an incoming signal.

Further features and advantages of the invention will be apparent from the description below.

Embodiments of the invention will now be described, by way of example, with reference to the accompanying drawings, in which:

Figure 1 is a block diagram of a multiple-order polynomial predistorter;

Figure 2 is a block diagram of a circuit for generating a third order distortion component suitable for use in the polynomial predistorter of Figure 1;

Figure 3 is a block diagram of a feedback control circuit for use in the circuit of Figure 2;

Figure 4 is a block diagram of an enhanced feedback control circuit using digital signal processing techniques for use in the circuit of Figure 2;

Figures 5 is a block diagram of a circuit for generating third and fifth order distortion components suitable for use in the polynomial predistorter of Figure 1;

Figure 6 is a block diagram of an alternative circuit for generating third and fifth order distortion components suitable for use in the polynomial predistorter of Figure 1;

Figure 7 is a block diagram of a circuit for generating a fifth order distortion component, based on the circuit of Figure 5 and including a feedback control circuit;

Figure 8 is a block diagram of a circuit for generating third and fifth order distortion components, based on the circuits of Figure 2 and Figure 7 and including a feedback control circuit;

Figure 9 is a block diagram of a feedback control circuit for use in the circuit of Figure 8, based on the circuit of Figure 4;

Figure 10 is a block diagram of a circuit for generating third, fifth, and seventh order distortion components suitable for use in the polynomial predistorter of Figure 1; and

Figures 11a, 11b, 11c, 11d, 11e, 11f are frequency spectra for signals occurring at various points in the circuits of Figures 1 to 10 in operation.

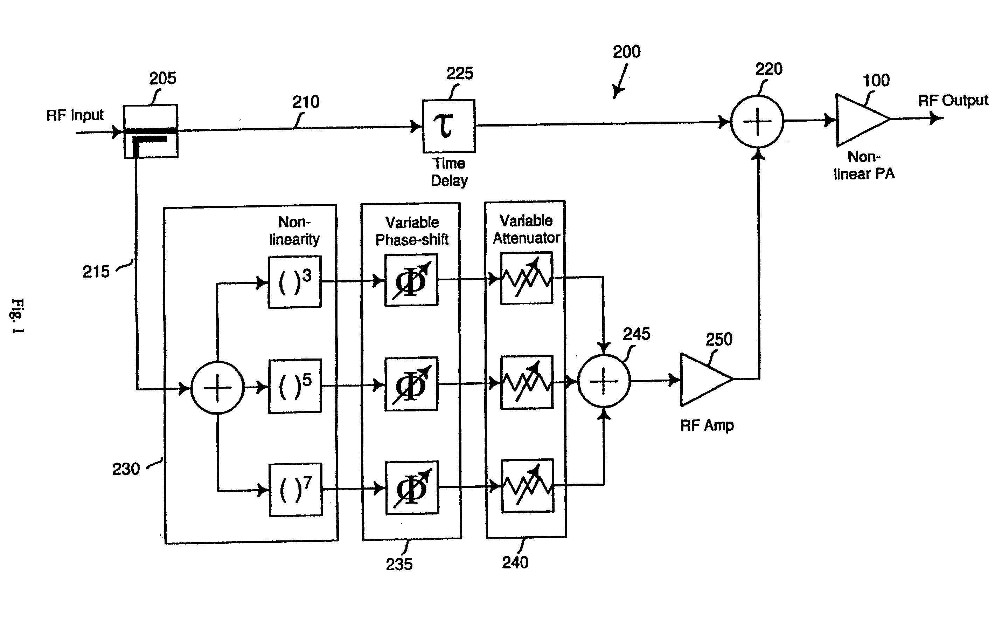

Referring to Figure 1, there is shown a multiple order polynomial predistorter 200 having an input for receiving an RF input signal and an output for supplying a predistorted signal to an RF power amplifier 100. The RF input signal received at the input of the predistorter is split by the splitter 205 between two channels or paths, the main path 210 supplying the main RF input signal for subsequent amplification, and the distortion path 215 supplying multiple orders of distortion for adding to the main RF input signal.

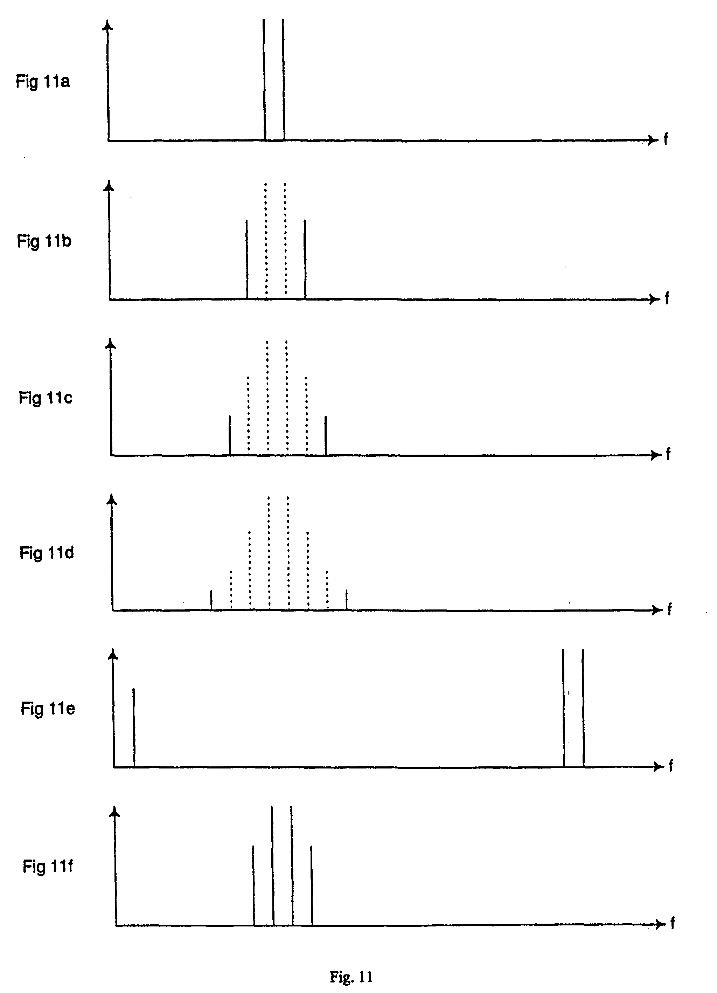

The main RF input signal from the main path 210 and the distortion signal from the distortion path 215 are summed in the adder 220 prior to being amplified in the RF power amplifier 100. The main path includes a time delay component 225 to ensure that the main RF signal and the distortion signal coincide at the adder 220. In an ideal operation of the predistorter, the output signal from the RF power amplifier 100 will represent a linearly amplified version of the RF input signal as discussed previously. An example of a possible RF input signal in the form of two closely spaced frequency tones is shown in Figure 11a.

The RF signal entering the distortion path 215 is fed into a distortion generation circuit 230 which operates on the RF input signal to generate a set of non-linear distortion components each corresponding to a particular order of distortion. In Figure 1, the orders of distortion generated at the three output paths of the distortion generation circuit 230 are third order, fifth order, and seventh order, illustrated as frequency spectra in Figures 11b, 11c and 11d respectively. It is also possible for the distortion generation circuit to generate higher order distortion components such as ninth order, or to generate only third order, or third and fifth order distortion components.

The signals output from the distortion generating circuit 230 are independently adjusted in phase by the set of variable phase-shift components 235 to compensate for any differing phase shifts occurring in the distortion generating circuit 230. The distortion signals are then independently adjusted in amplitude by the set of variable attenuators 240. The amplitude adjustment ensures that the relative levels of the separate distortion components are set to correctly correspond to the relative levels of the orders of distortion generated intrinsically in the RF power amplifier 100.

The correctly adjusted signals representing the third, fifth and seventh orders of distortion are then summed in the adder 245 to produce a single multiple order distortion signal. This signal is fed into an RF amplifier 250 which controls the level of the multiple order distortion signal relative to the main RF signal on the main path 210.

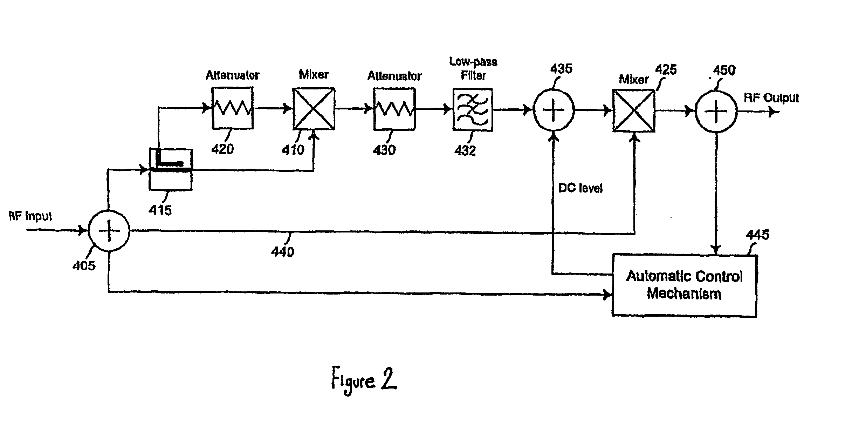

Figure 2 shows a block diagram of a circuit for generating a third order distortion component. The RF input signal entering the circuit is split three ways by the splitter 405. One of the RF signals is then fed into the first input of a mixer or multiplier 410 via a directional coupler 415. The directional coupler samples a portion of the RF signal which is fed into the second input of the mixer 410 via an attenuator 420. By mixing the two versions of the same RF input signal, the output of the mixer 410 ideally generates a squared RF signal which contains frequency components in a DC zone, i.e. at low frequencies, and frequency components in a first harmonic zone, i.e. at double the original frequencies. The frequency spectra of the squared RF signal is represented in Figure 11e.

The squared RF signal output from the mixer 410 is then fed into the first input of a mixer 425 via an attenuator 430 and a DC injection summer 435. Another RF input signal from the splitter forms the second input to the mixer 425 and may be supplied via a path 440 including a time delay element (not shown) to ensure that the two mixer input signals are in phase. By mixing the squared RF signal with the original RF input signal, the output of the mixer 425 ideally produces a pure cubic signal. The frequency spectra of the cubed RF signal is represented in Figure 11f (after filtering to eliminate the DC-zone, harmonic and third harmonic components)

The cubed RF signal should, ideally, consist of only input RF signal energy, plus in-band third-order components. In practice however other higher orders of in-band distortion will also be present in the output of the mixer 425, together with more input signal energy than would be expected from a theoretical analysis. The attenuation values for the attenuators 420 and 430, and the coupling factor for the coupler 415 are chosen to optimise performance with the type of mixers 410 and 425. Optimum performance is a compromise between minimising the unwanted input signal energy, caused by leakage through the mixers, and minimising the higher orders of in-band distortion, caused by non-ideal performance of the mixers 410 and 425. In a circuit having a 0 dBm RF input signal level and implementing standard Gilbert-cell based silicon IC mixers, the difference between the "LO", "RF" or "IF" drive levels will typically be in the order of 20 dB in each case.

In the third order distortion generator circuit of Figure 2, the squared RF signal output from the mixer 410 is filtered before entering the mixer 425. This enables selection of either the DC zone frequency components of the squared RF signal by means of a low pass filter (as illustrated: LPF432), or the second harmonic zone frequency components of the squared RF signal by means of a high pass filter. Each selection scheme has its own particular benefits, however, both schemes advantageously provide attenuation of the input tone energy at the output, when used in conjunction with the DC-based input tone rejection mechanism described below.

In the low pass filter version (note that protection is claimed only for apparatus and methods using such low-pass filtering), the selection of the DC zone in practice provides a better behaved response in terms of gain and phase flatness than the second harmonic zone and as a result can provide better coherence between the two third order distortion components shown in Figure 11b. Although the gain and phase flatness of the second harmonic zone version is effected by the high frequency response of the circuit elements, this version has the benefit of producing a output spectrum in which the input tone level is at a similar level to the third order distortion components, without additional correction.

In order to enable improved control of the third order component generation, it is preferable to remove as much of the input tone energy present in the output as possible. Referring to the circuit of Figure 2, this is achieved by injecting a DC signal via an adder 435 to the squared RF signal at an appropriate level such that when mixed with the RF input signal the input energy at the output of the circuit is cancelled. The position of the DC signal injection shown in Figure 2 is preferable as the level of RF input to the mixer 425 is relatively high and is known to a high degree of certainty. The same cancellation of the input energy can however be achieved, albeit less efficiently and less predictably, by injecting a DC signal at other positions in the distortion generation circuit. For example, an alternative position for DC injection could be into the path 440 carrying the RF input signal to the mixer 425. The DC signal would then cancel any leakage of a spurious RF input signal present in the squared RF signal resulting from leakage through the mixer 410. DC signal injection may also be possible in the signal paths leading to the mixer 410.

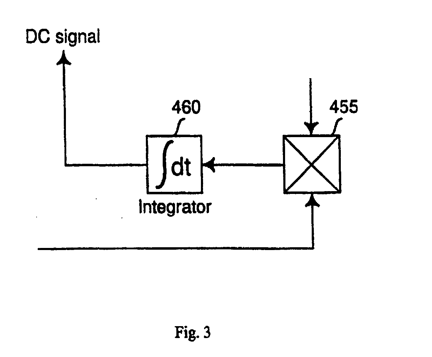

Although the DC signal level may be set to maximise cancellation of the input signal energy in the output of the distortion generating circuit, fluctuations and drifting of the various signals within the circuit will occur as a result of, for example, temperature variations of circuit components, aging of circuit components, and unpredictable variations in supply voltages (see earlier comment on input signal levels). The distortion generation circuit therefore includes an automatic control mechanism 445 for initialising, maintaining, and controlling the DC signal at the correct level for maximum cancellation of the input signal energy. The automatic control mechanism operates using a feedback loop principle. The output of the distortion generation circuit is sampled by a splitter 450 and is fed into an input of the control mechanism. A second input of the control mechanism receives an RF input signal from the splitter 405, preferably via a time delay element (not shown), and functions as a reference signal for the RF input. The automatic control mechanism compares the sample from the output with the RF input reference signal, and provides as an output a DC signal level dependent on the level of RF input energy detected in the output sample. Figure 3 shows one implementation of the automatic control mechanism in which a detection mixer 455 receives at one input the sample of the output signal and at another input the reference input signal. The detection mixer outputs a signal containing components across a range of frequencies. However, the output of the detection mixer of interest is the DC signal component, which provides a measure of the overlap of the unwanted input signal energy in the output with the reference input signal. This DC output is isolated from the other signal components in the detection mixer output by integration of the output in the integrator 460. The integrator has a time constant long enough to remove the unwanted non-DC signal components but short enough to provide millisecond response in the feedback. The DC output of the integrator provides the DC signal for injection into the adder 435.

A drawback with this control mechanism is that the detection mixer and the integrator may generate DC offset signals which become dominant over the feed back control DC signals. This typically occurs when the level of rejection of the input energy is in the order of 10 - 15 dB. It is possible to use more accurate mixers and integrators to achieve lower DC offsets to counteract this effect. However, mixers and integrators of this kind tend to be rarer and more expensive.

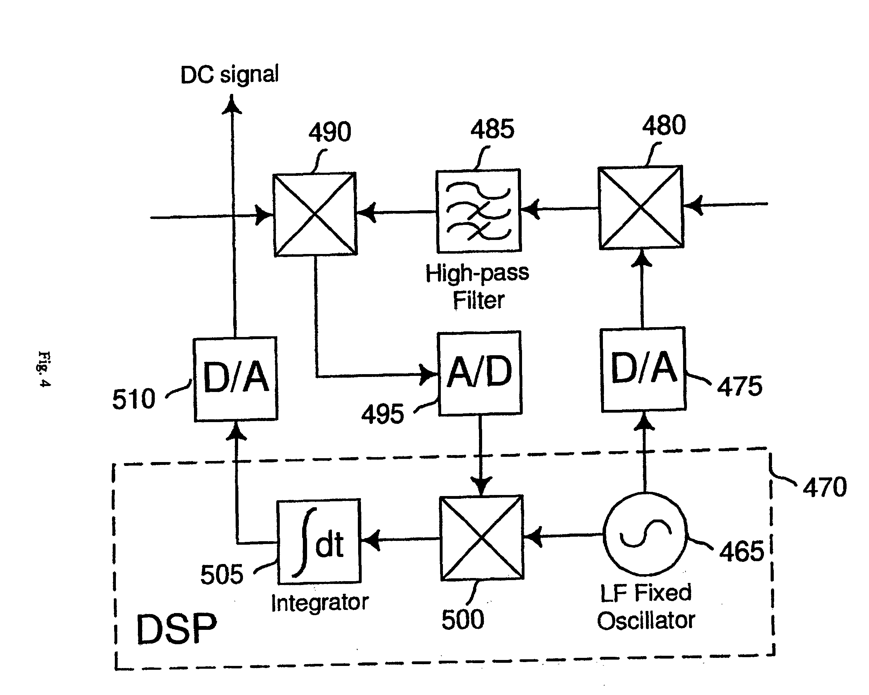

Figure 4 shows a modified automatic control mechanism which incorporates offset frequency and digital signal processing (DSP) techniques to eliminate the DC offset problem referred to above. Although the circuit is more complex than the circuit of Figure 3, integration of the non-DSP components on an application specific integrated circuit (ASIC) chip means that the higher component count should not add significantly to the cost of this solution. The automatic control mechanism includes the same two inputs and one output as the circuit of Figure 3, and operates as follows. A low frequency (LF) fixed oscillator 465 operating in the digital domain of a digital signal processor (DSP) 470 provides via a digital-to-analogue converter 475 a low frequency tone signal to an input of a mixer 480. The LF tone signal is ideally at an audio frequency $f_{LF}$ of between 1 and 5 kHz. The second input to the mixer 480 is the output sample supplied by the splitter 450 shown in Figure 2, and contains signal components at a relatively higher frequency than the LF tone signal, e.g. between 500 to 2000 MHz. The effect of mixing the output sample with the LF tone signal is to generate an image of the output sample shifted down in frequency by $f_{LF}$ and an image of the output sample shifted up in frequency by $f_{LF}$. The output of the mixer 480 is processed by a high pass filter 485 which has a cutoff frequency chosen such that the filter 485 removes any LF tone signal leaking through the mixer 480. The frequency offset output sample is then fed into an input of a detection mixer 490, whilst a second input receives the reference RF input signal. As in the mechanism of Figure 3, the detection mixer 490 provides at its output a signal containing components across a range of frequencies. However, in this mechanism it is the signal component at the tone frequency $f_{LF}$ which provides a measure of the overlap of the unwanted input signal energy in the output with the reference input signal.

After converting the output of the detection mixer 490 back into the digital domain of the digital signal processing (DSP) using the analogue-to-digital converter 495, the signal is fed into a digital mixer 500. It should be noted that the digital signal processor and the analogue-to digital converter are ideally suited to dealing with signals at audio frequency and can therefore accurately process the required signal component at the tone frequency $f_{LF}$. The digital mixer 500 mixes the output of the detection mixer 490 with the LF tone signal from the LF fixed oscillator 465 to convert the required signal component also at the tone frequency to a DC signal. As in the mechanism of Figure 3, this DC signal is isolated from the other signal components produced in the detection mixer by integration of the digital mixer output in a digital integrator 505. However, unlike the mechanism of Figure 3, this offset-frequency mechanism is immune to any build up of spurious DC signals in the analogue domain, i.e. in the mixers 480, 490, the D/A 475, the A/D 495 and the high-pass filter 485. The potentially damaging DC signals enter the digital signal processor via the analogue to digital converter (A/D) 495, but are immediately converted to the tone signal frequency $f_{LF}$ by the digital mixer 500 and are subsequently cancelled in the integrator 505. Because the digital mixer 500 and the integrator 505 both operate in the digital domain of the digital signal processor (DSP) they do not experience the problems of their analogue counterparts such as signal leakage or spurious DC offset generation due to temperature or power supply fluctuations. The DC signal output from the integrator provides via the digital-to-analogue converter 510 the DC signal for injection into the adder 435 of Figure 2.

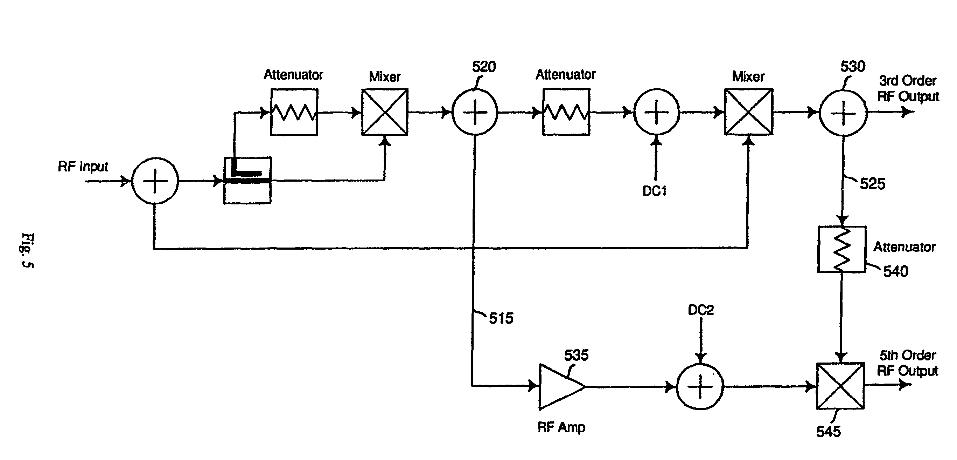

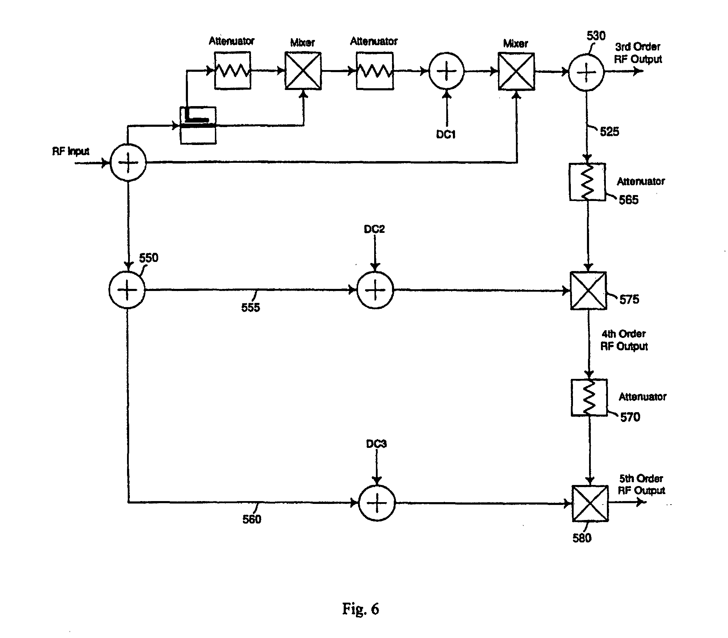

Figures 5 and 6 are block diagrams of two alternative embodiments of a circuit for generating third and fifth order distortion components, and are based on the design and basic principles of operation of the third order generation circuit of Figure 2. Like components have therefore been labelled with like references.

In the generation circuit of Figure 5, the second order signal is divided into a second path 515 by a splitter 520, and the third order signal is divided into a second path 525 by a splitter 530. The second order signal level on the path 515, and the third order signal level on the path 525, are adjusted by an RF amplifier 535 and an attenuator 540 respectively. The adjusted second and third order signals are then mixed in the mixer 545 to produce a fifth order RF output. A second DC injection signal is added to the second order signal path 515 for mixing with the third order signal on the path 525. By adjusting the second DC signal to a suitable level, the third order signals, which would otherwise be present in the fifth order RF output, may be cancelled.

In the generation circuit of Figure 6, the RF input signal is further divided by a splitter 550 into paths 555 and 560, and the third order signal is divided by a splitter 530 into a path 525. The third order signal is suitably attenuated by attenuators 565 and 570 which in turn feed the mixers 575 and 580. The mixers 575 and 580 mix the third order signal with the RF input signals on the paths 555 and 560 respectively. The output of the first mixer 575 generates a fourth order signal, and the output of the second mixer 580 generates the fifth order distortion signal for outputting.

Simulations performed on the generation circuit of Figure 5 have shown that for fifth order distortion generation the first DC injection (DC1) to the adder 435 may not be required. The third DC injection can provide significant cancellation of both the main signal energy and the third order energy leaving only the desired fifth order distortion. Removal of the first and second DC injections allow for simpler control of the fifth order distortion generation, however, a drawback in this solution is that the third order output no longer contains a pure third order distortion signal.

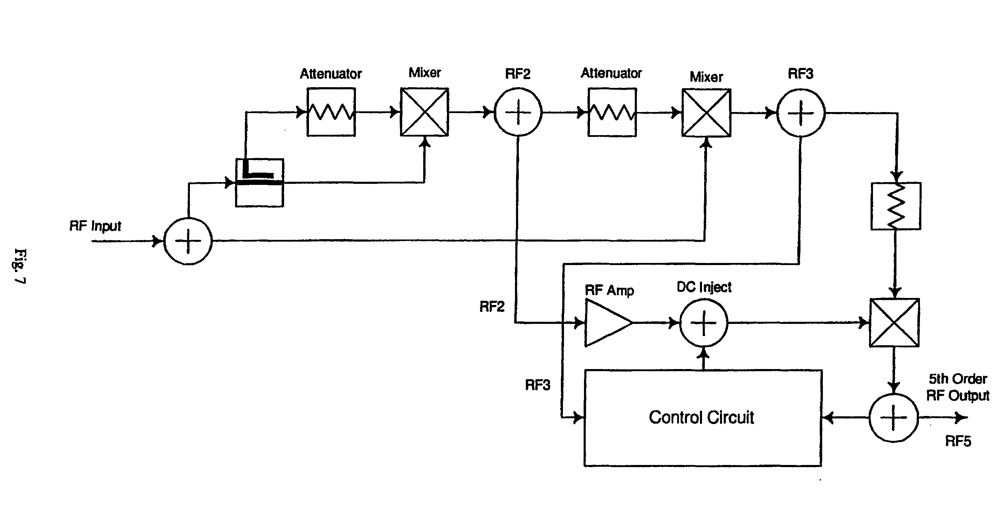

Figure 7 shows the circuit of Figure 5 with a feedback control mechanism which controls and maintains the second DC injection to the adder. This feedback control mechanism performs in a similar way as in the third order generation circuit, except that a sample of the fifth order output is compared with a reference signal sampled from the third order output. The feedback DC signal therefore provides a measure of the overlap of both the unwanted input signal energy and third order signal energy in the fifth order output. The feedback control mechanism may be implemented using the feedback circuits of Figures 3 or 4.

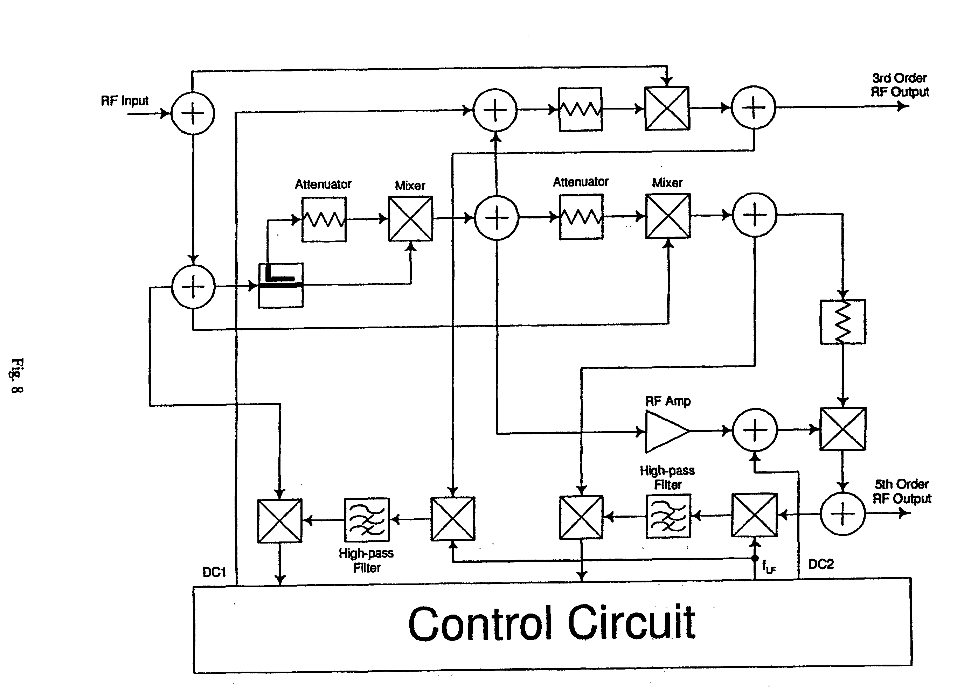

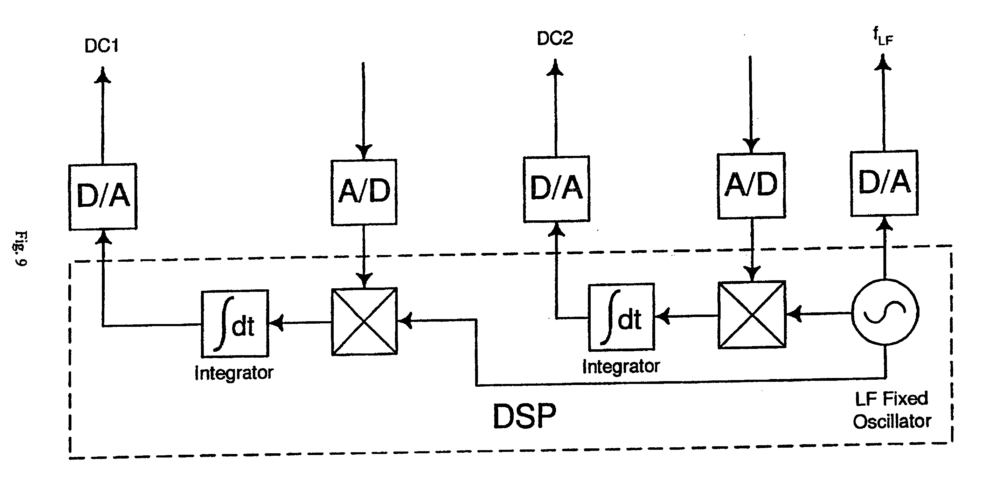

Figure 8 is a block diagram showing a third order and a fifth order distortion generation circuit with a combined control. The circuit is a combination of the third order generation circuit of Figure 2 and the fifth order generation circuit of Figure 7. The combined feedback control mechanism for this circuit is shown in Figure 9 and is based on the offset frequency mechanism of Figure 4.

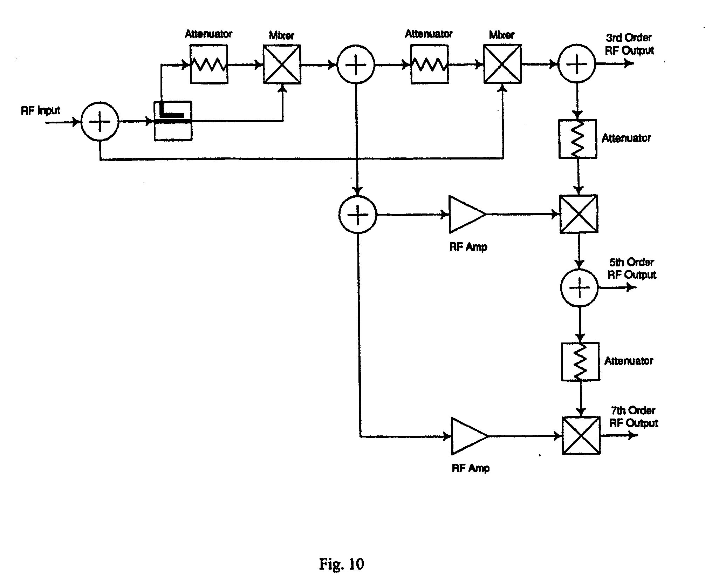

Figure 10 is a block diagram showing a circuit for generating a seventh order distortion signal based on the principle used in the fifth order generation circuit of Figure 5. The fifth order signal is combined with the second order signal to generate a seventh order distortion output.

It will be evident in view of the foregoing that various modifications may be made within the scope of the present invention. For example, the description refers to the use of certain components such as mixers and integrators which could be replaced by multipliers and low-pass filters respectively.

## Claims

1. A circuit for deriving a third order signal from an input signal, comprising input means (405) for providing an input signal to the circuit along first, second and third paths, means (410) for combining the input signal from the first and second paths to produce a second order signal on a squared signal path, means for low-pass filtering the second order signal to remove components at the frequency of the input signal and harmonics thereof and means (425) for combining the filtered second order signal from the squared signal path with the input signal from the third path to produce a third order signal.

2. A circuit as claimed in claim 1, for additionally deriving a fifth order signal from an input signal, further comprising means for providing the second order signal along a second squared signal path (515), and means (545) for combining the second order signal from the second squared signal path with the third order signal to produce a fifth order signal.

3. A circuit as claimed in claim 1, for additionally deriving a fifth order signal from an input signal, wherein the input means provides the input signal along fourth (555) and fifth (560) paths, and further comprises means for combining the input signal from the fourth path with the third order signal to produce a fourth order signal, and means (580) for combining the input signal from the fifth path with the fourth order signal to produce a fifth order signal.

4. A circuit as claimed in any one of the preceding claims, wherein the input signal is a radio frequency signal.

5. A circuit as claimed in any one of the preceding claims, further comprising means for injecting a direct current signal into at least one of the signal paths.

6. A circuit as claimed in claim 5, wherein the d.c injecting means is arranged to inject the direct current signal into the squared signal path for adding to the second order signal to cancel input signal energy in the third order signal.

7. A circuit as claimed in claim 6, further comprising error correction means arranged to compare the third order signal with the input signal to produce an error correction signal for controlling the injection of the direct current signal into the squared signal path.

8. A circuit as claimed in claim 7, wherein in the error correction means is arranged to translate the frequency of the third order signal by an oscillator signal prior to correlation with the input signal to produce a correlation signal which is processed in a digital signal processor by comparison with the oscillator signal to produce the error correction signal.

9. A circuit as claimed in claim 5, further comprising means for injecting the direct current signal into the second squared signal path for adding to the second order signal to cancel input signal energy and third order signal energy in the fifth order signal.

10. A circuit as claimed in claim 7, further comprising error correction means arranged to compare the fifth order signal with the third order signal to produce an error correction signal for controlling the injection of the direct current signal into the second squared signal path.

11. A circuit as claimed in any one of the preceding claims, wherein the combining means are mixers or multipliers.

12. A circuit as claimed in any one of the preceding claims, wherein the input means comprises at least one splitter for providing the input signal along the signal paths.

13. A circuit as claimed in any one of the preceding claims, wherein the input means comprises at least one directional coupler for providing the input signal along the signal paths.

14. A polynomial predistorter including a circuit as claimed in claim 1.

15. A method of deriving a third order predistorkion signal from an input signal, comprising providing an input signal to a circuit along first, second and third paths, combining the input signal from the first and second paths to produce a second order signal on a squared signal path, low-pass filtering the second order signal to remove components at the frequency of the input signal and harmonics thereof, and combining the filtered second order signal from the squared signal path with the input signal from the third path to produce a third order signal.

16. A circuit as claimed in any one of claims 1 to 13, further comprising means for creating at least one further, different, odd-order signal, each said distinct, further odd-order signal being created by combining the input signal with itself.

17. A polynomial predistorter according to claim 14, further comprising means for creating at least one further, different, odd-order signal, each said distinct, further odd-order signal being created by combining the input signal with itself.

18. A method according to claim 15, further comprising creating at least one further, different, odd-order signal, each said distinct, further odd-order signal being created by combining the input signal with itself.

**Patentansprüche**

1. Schaltung zum Ableiten eines Signals dritter Ordnung von einem Eingangssignal, umfassend Eingangsmittel (405) zum Liefern eines Eingangssignals zu der Schaltung entlang einem ersten, zweiten und dritten Pfad, Mittel (410) zum Kombinieren des Eingangssignals von dem ersten und zweiten Pfad zur Erzeugung eines Signals zweiter Ordnung auf einem rechteckigen Signalpfad, Mittel zum Tiefpassfiltem des Signals zweiter Ordnung zum Entfernen von Komponenten mit der Frequenz des Eingangssignals und Harmonischen davon, und Mittel (425) zum Kombinieren des gefilterten Signals zweiter Ordnung von dem rechteckigen Signalpfad mit dem Eingangssignal von dem dritten Pfad zum Erzeugen eines Signals dritter Ordnung.

2. Schaltung gemäß Anspruch 1, zum zusätzlichen Ableiten eines Signals fünfter Ordnung von einem Eingangssignal, des Weiteren umfassend Mittel zum Liefern des Signals zweiter Ordnung entlang einem zweiten rechteckigen Signalpfad (515), und Mittel (545) zum Kombinieren des Signals zweiter Ordnung von dem zweiten rechteckigen Signalpfad mit dem Signal dritter Ordnung zum Erzeugen eines Signals fünfter Ordnung.

3. Schaltung gemäß Anspruch 1 zum zusätzlichen Ableiten eines Signals fünfter Ordnung von einem Eingangssignal, wobei das Eingabemittel das Eingangssignal entlang einem vierten (555) und einem fünften (560) Pfad bereitstellt, die des Weiteren Mittel zum Kombinieren des Eingangssignals von dem vierten Pfad mit dem Signal dritter Ordnung umfasst, um ein Signal vierter Ordnung zu erzeugen, und Mittel (580) zum Kombinieren des Eingangssignals von dem fünften Pfad mit dem Signal vierter Ordnung, um ein Signal fünfter Ordnung zu erzeugen.

4. Schaltung gemäß einem der vorhergehenden Ansprüche, wobei das Eingangssignal ein Radiofrequenzsignal ist.

5. Schaltung gemäß einem der vorhergehenden Ansprüche, des Weiteren umfassend Mittel zum Einspeisen eines Gleichstromsignals in wenigstens einen der Signalpfade.

6. Schaltung gemäß Anspruch 5, wobei das Gleichstromeinspeisungsmittel zum Einspeisen des Gleichstromsignals in den rechteckigen Signalpfad zum Hinzufügen zu dem Signal zweiter Ordnung angeordnet ist, um Eingangssignalenergie in dem Signal dritter Ordnung zu löschen.

7. Schaltung gemäß Anspruch 6, des Weiteren umfassend Fehlerkorrekturmittel, die zum Vergleichen des Signals dritter Ordnung mit dem Eingangssignal angeordnet sind, um ein Fehlerkorrektursignal zum Steuern der Einspeisung des Gleichstromsignals in den rechteckigen Signalpfad zu erzeugen.

8. Schaltung gemäß Anspruch 7, wobei das Fehlerkorrekturmittel zum Umsetzen der Frequenz des Signals dritter Ordnung durch ein Oszillatorsignal vor dem Korrelieren mit dem Eingangssignal angeordnet ist, um ein Korrelationssignal zu erzeugen, das in einem Digitalsignalprozessor durch einen Vergleich mit dem Oszillatorsignal verarbeitet wird, um das Fehlerkorrektursignal zu erzeugen.

9. Schaltung gemäß Anspruch 5, des Weiteren umfassend Mittel zum Einspeisen des Gleichstromsignals in den zweiten rechteckigen Signalpfad zum Hinzufügen zu dem Signal zweiter Ordnung, um Eingangssignalenergie und Energie des Signals dritter Ordnung in dem Signal fünfter Ordnung zu löschen.

10. Schaltung gemäß Anspruch 7, des Weiteren umfassend Fehlerkorrekturmittel, die zum Vergleichen des Signals fünfter Ordnung mit dem Signal dritter Ordnung angeordnet sind, um ein Fehlerkorrektursignal zum Steuern der Einspeisung des Gleichstromsignals in den zweiten rechteckigen Signalpfad zu erzeugen.

11. Schaltung gemäß einem der vorhergehenden Ansprüche, wobei die Kombiniermittel Mischer oder Vervielfacher sind.

12. Schaltung gemäß einem der vorhergehenden Ansprüche, wobei das Eingabemittel wenigstens einen Teiler zum Bereitstellen des Eingangssignals entlang den Signalpfaden umfasst.

13. Schaltung gemäß einem der vorhergehenden Ansprüche, wobei das Eingabemittel wenigstens einen Richtungskoppler zum Bereitstellen des Eingangssignals entlang den Signalpfaden umfasst.

14. Polynomischer Vorverzerrer mit einer Schaltung gemäß Anspruch 1.

15. Verfahren zum Ableiten eines Vorverzerrungssignals dritter Ordnung von einem Eingangssignal, umfassend das Liefern eines Eingangssignals zu einer Schaltung entlang einem ersten, zweiten und dritten Pfad, Kombinieren des Eingangssignals von dem ersten und zweiten Pfad zur Erzeugung eines Signals zweiter Ordnung auf einem rechteckigen Signalpfad, Tiefpassfiltern des Signals zweiter Ordnung zum Entfernen von Komponenten mit der Frequenz des Eingangssignals und von Harmonischen derselben, und zum Kombinieren des gefilterten Signals zweiter Ordnung von dem rechteckigen Signalpfad mit dem Eingangssignal von dem dritten Pfad zum Erzeugen eines Signals dritter Ordnung.

16. Schaltung gemäß einem der Ansprüche 1 bis 13, des Weiteren umfassend Mittel zum Schaffen von wenigstens einem weiteren anderen Signal ungerader Ordnung, wobei jedes andere weitere Signal ungerader Ordnung durch Kombinieren des Eingangssignals mit sich selbst erzeugt wird.

17. Polynomischer Vorverzerrer gemäß Anspruch 14, des Weiteren umfassend Mittel zum Schaffen von wenigstens einem weiteren anderen Signal ungerader Ordnung, wobei jedes andere weitere Signal ungerader Ordnung durch Kombinieren des Eingangssignals mit sich selbst erzeugt wird.

18. Verfahren gemäß Anspruch 15, des Weiteren umfassend das Schaffen von wenigstens einem weiteren anderen Signal ungerader Ordnung, wobei jedes andere weitere Signal ungerader Ordnung durch Kombinieren des Eingangssignals mit sich selbst erzeugt wird.

**Revendications**

1. Circuit pour dériver un signal de troisième ordre à partir d'un signal d'entrée, comportant des moyens d'entrée (405) pour délivrer un signal d'entrée au circuit le long de premier, deuxième et troisième trajets, des moyens (410) pour combiner le signal d'entrée provenant des premier et deuxième trajets afin de produire un signal de deuxième ordre sur un trajet de signal élevé au carré, des moyens pour réaliser un filtrage passe-bas du signal de deuxième ordre pour supprimer des composantes à la fréquence du signal d'entrée et à des harmoniques de celle-ci, et des moyens (425) pour combiner le signal de deuxième ordre filtré provenant du trajet de signal élevé au carré avec le signal d'entrée provenant du troisième trajet afin de produire un signal de troisième ordre.

2. Circuit selon la revendication 1, pour dériver de plus un signal de cinquième ordre à partir d'un signal d'entrée, comportant en outre des moyens pour délivrer le signal de deuxième ordre le long d'un deuxième trajet de signal élevé au carré (515), et des moyens (545) pour combiner le signal de deuxième ordre provenant du deuxième trajet de signal élevé au carré avec le signal de troisième ordre afin de produire un signal de cinquième ordre.

3. Circuit selon la revendication 1, pour dériver de plus un signal de cinquième ordre à partir d'un signal d'entrée, dans lequel les moyens d'entrée délivrent le signal d'entrée le long de quatrième (555) et cinquième (560) trajets, et comportent en outre des moyens pour combiner le signal d'entrée provenant du quatrième trajet avec le signal de troisième ordre afin de produire un signal de quatrième ordre, et des moyens (550) pour combiner le signal d'entrée provenant du cinquième trajet avec le signal de quatrième ordre afin de produire un signal de cinquième ordre.

4. Circuit selon l'une quelconque des revendications précédentes, dans lequel le signal d'entrée est un signal radiofréquence.

5. Circuit selon l'une quelconque des revendications précédentes, comportant en outre des moyens pour injecter un signal à courant continu dans au moins l'un des trajets de signal.

6. Circuit selon la revendication 5, dans lequel les moyens d'injection de courant continu sont agencés pour injecter le signal à courant continu dans le trajet de signal élevé au carré pour l'ajouter au signal de deuxième ordre afin d'annuler l'énergie du signal d'entrée dans le signal de troisième ordre.

7. Circuit selon la revendication 6, comportant en outre des moyens de correction d'erreur agencés pour comparer le signal de troisième ordre au signal d'entrée afin de produire un signal de correction d'erreur pour commander l'injection du signal à courant continu dans le trajet de signal élevé au carré.

8. Circuit selon la revendication 7, dans lequel les moyens de correction d'erreur sont agencés pour transposer la fréquence du signal de troisième ordre par un signal d'oscillation avant la corrélation avec le signal d'entrée afin de produire un signal de corrélation qui est traité dans un processeur de signaux numériques par comparaison au signal d'oscillation afin de produire le signal de correction d'erreur.

9. Circuit selon la revendication 5, comportant en outre des moyens pour injecter le signal à courant continu dans le deuxième trajet de signal élevé au carré pour l'ajouter au signal de deuxième ordre afin d'annuler l'énergie du signal d'entrée et l'énergie du signal de troisième ordre dans le signal de cinquième ordre.

10. Circuit selon la revendication 7, comportant de plus des moyens de correction d'erreur agencés pour comparer le signal de cinquième ordre au signal de troisième ordre afin de produire un signal de correction d'erreur pour commander l'injection du signal à courant continu dans le deuxième trajet de signal élevé au carré.

**11.** Circuit selon l'une quelconque des revendications précédentes, dans lequel les moyens de combinaison sont des mélangeurs ou des multiplieurs.

**12.** Circuit selon l'une quelconque des revendications précédentes, dans lequel les moyens d'entrée comportent au moins un diviseur pour délivrer le signal d'entrée le long des trajets de signal.

**13.** Circuit selon l'une quelconque des revendications précédentes, dans lequel les moyens d'entrée comportent au moins un coupleur directif pour délivrer le signal d'entrée le long des trajets de signal.

**14.** Générateur de prédistorsion polynomial incluant un circuit selon la revendication 1.

**15.** Procédé de dérivation d'un signal de prédistorsion de troisième ordre à partir d'un signal d'entrée, comportant la délivrance d'un signal d'entrée à un circuit le long de premier, deuxième et troisième trajets, la combinaison du signal d'entrée provenant des premier et deuxième trajets pour produire un signal de deuxième ordre sur un trajet de signal élevé au carré, le filtrage passe-bas du signal de deuxième ordre pour supprimer des composantes à la fréquence du signal d'entrée et à des harmoniques de celle-ci, et la combinaison du signal de deuxième ordre filtré provenant du trajet de signal élevé au carré avec le signal d'entrée provenant du troisième trajet afin de produire un signal de troisième ordre.

**16.** Circuit selon l'une quelconque des revendications 1 à 13, comportant en outre des moyens pour créer au moins un signal supplémentaire distinct d'ordre impair, chacun desdits signaux supplémentaires distincts d'ordre impair étant créé en combinant le signal d'entrée à lui-même.

**17.** Générateur de prédistorsion polynomial selon la revendication 14, comportant en outre des moyens pour créer au moins un signal supplémentaire distinct d'ordre impair, chacun desdits signaux supplémentaires distincts d'ordre impair étant créé en combinant le signal d'entrée à lui-même.

**18.** Procédé selon la revendication 15, comportant en outre la création d'au moins un signal supplémentaire distinct d'ordre impair, chacun desdits signaux supplémentaires distincts d'ordre impair étant créé en combinant le signal d'entrée à lui-même.

Fig. 1

Figure 2

EP 1 066 680 B1

DC signal

Fig. 3

Fig. 4

Fig. 5

Fig. 6

Fig. 7

17

Fig. 8

Fig. 9

19

Fig. 10

Fig 11a

Fig 11b

Fig 11c

Fig 11d

Fig 11e

Fig 11f

Fig. 11